# EUROPEAN PATENT SPECIFICATION

(11) **EP 2 348 530 B1**
(45) Date of publication and mention of the grant of the patent: **09.03.2016**
(21) Application number: 09817584.7
(22) Date of filing: 07.08.2009
(51) Int. Cl.: H01L 29/12, H01L 21/28, H01L 21/336, H01L 21/337, H01L 29/417, H01L 29/78, H01L 29/808, H01L 29/861

(54) **SILICON CARBIDE SEMICONDUCTOR DEVICE**
HALBLEITERBAUELEMENT AUS SILICIUMCARBID
DISPOSITIF À SEMI-CONDUCTEUR AU CARBURE DE SILICIUM

(30) Priority: 02.10.2008 JP 2008257280
(43) Date of publication of application: 27.07.2011
(73) Proprietor: Sumitomo Electric Industries, Ltd., Chuo-ku Osaka-shi Osaka 541-0041 (JP); National University Corporation Nara Institute of Science and Technology, Ikoma-shi, Nara 630-0192 (JP)
(72) Inventor: HARADA, Shin, Osaka-shi, Osaka 554-0024 (JP); TAMASO, Hideto, Osaka-shi, Osaka 554-0024 (JP); HATAYAMA, Tomoaki, Ikoma-shi, Nara 630-0192 (JP)
(74) Representative: Grünecker Patent- und Rechtsanwälte PartG mbB
(86) International application number: PCT/JP2009/064002
(87) International publication number: WO 2010/038547

(56) References cited:
- WO-A1-01/63020
- WO-A1-2006/135476
- CA-A1- 2 673 227
- JP-A- 2002 368 015
- JP-A- 2007 096 263
- JP-T- 2006 524 433
- US-A1- 2003 070 611
- US-A1- 2004 119 076
- US-A1- 2007 187 695
- MUELLER S G ET AL: "DEFECTS IN SIC SUBSTRATES AND EPITAXIAL LAYERS AFFECTING SEMICONDUCTOR DEVICE PERFORMANCE", EUROPEAN PHYSICAL JOURNAL APPLIED PHYSICS, EDP SCIENCES, LES ULIS, FR, vol. 27, no. 1-03, 1 July 2004 (2004-07-01), pages 29-35, XP007900218, ISSN: 1286-0042, DOI: 10.1051/EPJAP:2004085
- HEERA V ET AL: "p-Type doping of SiC by high dose Al implantation-problems and progress", APPLIED SURFACE SCIENCE, ELSEVIER, AMSTERDAM, NL, vol. 184, no. 1-4, 12 December 2001 (2001-12-12), pages 307-316, XP027322978, ISSN: 0169-4332 [retrieved on 2001-12-12]
- LEONARD ET AL: "100 mm 4HN-SiC Wafers with Zero Micropipe DensityLeonard; Khlebnikov; Powell et al", MATERIALS SCIENCE FORUM SILICON CARBIDE AND RELATED MATERIALS,, vol. 600-603, 1 January 2008 (2008-01-01), pages 7-10, XP009165751,

## Description

### TECHNICAL FIELD

The present invention relates to a silicon carbide semiconductor device, and more particularly, to a silicon carbide semiconductor device having an ohmic electrode.

### BACKGROUND ART

The silicon carbide semiconductor device such as an FET (field effect transistor) using silicon carbide (SiC) is conventionally known (for example, see "Semiconductor SiC Technology and Applications", page 191 (Non-Patent Document 1)). For example, while an MOSFET (Metal-Oxide-Semiconductor Field-Effect Transistor) using SiC is a unipolar device, a high reverse breakdown voltage (for example, 1 kV or more) that is achieved only by a bipolar transistor device such as a GTO (Gate Turn-Off thyristor) and an IGBT (Insulated Gate Bipolar Transistor) can be achieved in the case of the device using Si. Accordingly, such a device is expected to serve as a device that allows a high reverse breakdown voltage, low loss and fast switching. In addition, the MOSFET as a power device using Si is generally configured to employ a DMOSFET (Double-Diffused-MOSFET) structure. In the case of the MOSFET using SiC, conductive impurities are selectively doped by ion implantation. Thus, the MOSFET having conductive impurities implanted thereinto by such ion implantation is referred to as a DiMOSFET (Double-Implanted MOSFET).

### PRIOR ART DOCUMENTS

US 2004/0119076 A1 discloses a Vertical JFET SiC power MOS device having an ohmic electrode formed on a p-type impurity region.

US 2003/0070611 A1 discloses a method for manufacturing SiC single crystal or epitaxial films wherein a defect density of the SiC epitaxial film is in one embodiment from 10² to 10³ cm⁻³.

### NON-PATENT DOCUMENTS

Non-Patent Document 1: "Semiconductor SiC Technology and Applications", Nikkan Kogyo Shimbun-sha, Japan, March 31, 2003, p.191.

### SUMMARY OF THE INVENTION

### PROBLEMS TO BE SOLVED BY THE INVENTION

In the above-described MOSFET, an epitaxial layer made of SiC is formed on the surface of an SiC substrate, for example, having n type conductivity. Then, p type conductive impurities are ion-implanted into this epitaxial layer to form a p type region. Consequently, a p type ohmic electrode is formed so as to be in contact with the p type region.

In order to lower the contact resistance between the p type region and the ohmic electrode, it is conceivable to increase the concentration of the p type conductive impurities in the p type region (that is, increase the amount of the conductive impurities to be implanted). In this case, however, a lot of defects caused by ion implantation are formed in the p type region. These defects may act as a leak path of electric current, which causes deterioration of the reverse breakdown voltage performance of the MOSFET. Thus, in the semiconductor device using SiC, it is conventionally difficult follower the contact resistance between the ohmic electrode and the impurity region while achieving high reverse breakdown voltage characteristics.

The present invention has been made to solve the above-described problems, and an object of the present invention is to provide a silicon carbide semiconductor device capable of lowering the contact resistance of the ohmic electrode while achieving high reverse breakdown voltage characteristics.

### MEANS FOR SOLVING THE PROBLEMS

The silicon carbide semiconductor device according to the present invention solves the above problem by the features of claim 1. Thus, when an ohmic electrode is formed so as to be in contact with the impurity layer, the contact resistance between the ohmic electrode and the impurity layer can be lowered to the level at which there is no problem from a practical standpoint. In addition, the substrate having a dislocation density lowered to the above-mentioned value is used, thereby sufficiently lowering the density of the defects that may lead to a leak path in the substrate and in the impurity layer formed on the substrate. Consequently, the reverse breakdown voltage characteristics of the silicon carbide semiconductor device can be better.

### EFFECTS OF THE INVENTION

As described above, the present invention can provide a silicon carbide semiconductor device having excellent reverse breakdown voltage characteristics while capable of lowering the contact resistance of the ohmic electrode to the level at which there is no problem from a practical standpoint.

### BRIEF DESCRIPTION OF THE DRAWINGS

Fig. 1 is a schematic cross-sectional view of the first embodiment of a semiconductor device according to the present invention.
Fig. 2 is a flowchart for illustrating a method of manufacturing the semiconductor device shown in Fig. 1.
Fig. 3 is a schematic cross-sectional view of the second embodiment of a semiconductor device according to the present invention.
Fig. 4 is a flowchart for illustrating a method of manufacturing the semiconductor device shown in Fig. 3.
Fig. 5 is a schematic cross-sectional view of a sample of the inventive example produced for experiments.
Fig. 6 is a graph showing a concentration distribution of the conductive impurities in the depth direction from the outermost surface in a p⁺ type layer and a p type layer of the semiconductor device shown in Fig. 5.
Fig. 7 is a graph showing the current-voltage characteristics in the reverse direction about the sample of the inventive example of the present invention.
Fig. 8 is a graph showing the current-voltage characteristics in the reverse direction about the sample of Comparative Example 1.
Fig. 9 is a graph showing the measurement results in Comparative Example 2.
Fig. 10 is a graph showing the measurement results in Comparative Example 3.

### MODES FOR CARRYING OUT THE INVENTION

The embodiments of the present invention will be hereinafter described with reference to the drawings, in which the same or corresponding components are designated by the same reference characters, and description thereof will not be repeated.

### [First Example]

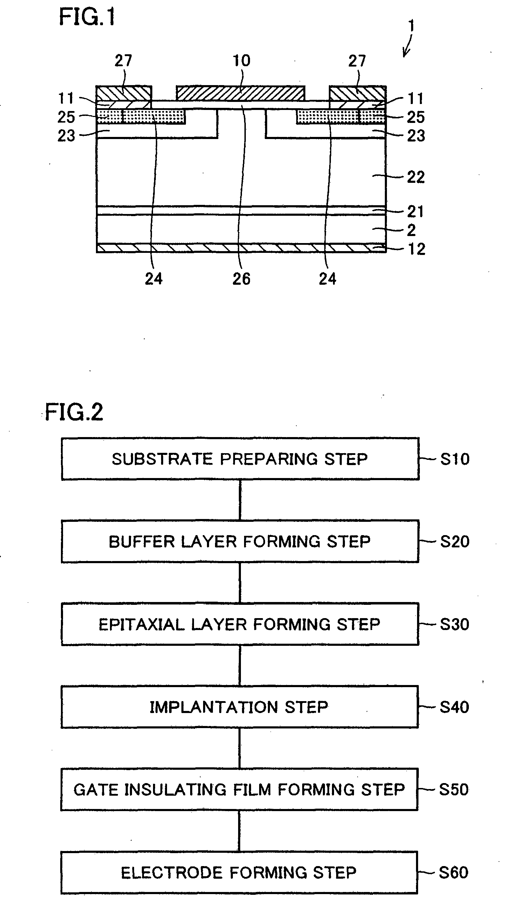

Referring to Fig. 1, the first example of the semiconductor device that can be formed according to the present invention will be described.

Referring to Fig. 1, a semiconductor device 1 according to the present invention is a vertical type DiMOSFET (Double Implanted MOSFET) which is an example of a silicon carbide semiconductor device. Semiconductor device 1 includes a substrate 2, a buffer layer 21, a reverse breakdown voltage holding layer 22, a p region 23, an n⁺ region 24, a p⁺ region 25, an oxide film 26, a source electrode 11 and an upper source electrode 27, a gate electrode 10, and a drain electrode 12 formed on the backside of substrate 2. Specifically, buffer layer 21 made of silicon carbide (SiC) is formed on the surface of substrate 2 made of silicon carbide (SiC) of n type conductivity. This buffer layer 21 of n type conductivity has a thickness of 0.5 µm, for example, and has an impurity concentration of 5 × 10¹⁷ cm⁻³, for example. Furthermore, reverse breakdown voltage holding layer 22 is formed on buffer layer 21. This reverse breakdown voltage holding layer 22 is made of silicon carbide of n type conductivity and has a thickness of 10 µm, for example. Furthermore, the concentration of the n type conductive impurities in reverse breakdown voltage holding layer 22 may be set, for example, at 5 × 10¹⁵ cm⁻³. In addition, the above-described buffer layer 21 may not be formed, but reverse breakdown voltage holding layer 22 may be formed directly on substrate 2.

Reverse breakdown voltage holding layer 22 has a surface on which p regions 23 of p type conductivity are formed spaced apart from each other. The concentration of the p type conductive impurities in p region 23 may be set, for example, at 1 × 10¹⁷ cm⁻³. Within p region 23, n⁺ region 24 is formed on the surface layer of p region 23. The concentration of the n type conductive impurities in n⁺ region 24 may be set, for example, at 1 × 10¹⁹ cm⁻³. Furthermore, p⁺ region 25 is formed in the position adjacent to n⁺ region 24. The concentration of the p type conductive impurities in n⁺ region 25 may be set, for example, at 1 × 10²⁰ cm⁻³. Oxide film 26 is formed so as to extend to cover the area from n⁺ region 24 in one p region 23 through the one p region 23, reverse breakdown voltage holding layer 22 exposed between two p regions 23, and the other p region 23 to n⁺ region 24 in the other p region 23. Gate electrode 10 is formed on oxide film 26. Furthermore, source electrode 11 is formed on n⁺ region 24 and p⁺ region 25. Upper source electrode 27 is formed on source electrode 11. In addition, drain electrode 12 is formed on the backside of substrate 2 opposite to the surface on which buffer layer 21 is formed.

In this case, the above-described semiconductor device 1 includes substrate 2 and p⁺ region 25 as an impurity layer. Substrate 2 is made of silicon carbide, has a dislocation density of 5 × 10³ cm⁻² or less and has the first conductive type (n type). Furthermore, p⁺ region 25 is formed on the substrate, in which the concentration of the conductive impurities having the second conductive type different from the first conductive type is 1 × 10²⁰ cm⁻³ or more and 5 × 10²¹ cm⁻² or less.

Thus, in the case where source electrode 11 serving as an ohmic electrode is formed so as to be in contact with p⁺ region 25, the contact resistance between source electrode 11 and p⁺ region 25 can be lowered to the level at which there is no problem from a practical standpoint. Furthermore, substrate 2 having a dislocation density lowered to the above-described value is used to allow a sufficient decrease in the density of the defects which may lead to a leak path in substrate 2 and the epitaxial layer and the like formed on the substrate. Accordingly, excellent reverse breakdown voltage characteristics of semiconductor device 1 can be achieved.

In addition, the dislocation density of substrate 2 can be measured by etching the surface of substrate 2 using a chemical solution such as KOH, and counting the number of etch pits produced by this etching process. Furthermore, the concentration of the conductive impurities in p⁺ region 25 can be measured, for example, using an SIMS (Secondary Ionization Mass Spectrometer) and the like.

Then, the operation of semiconductor device 1 shown in Fig. 1 will be described. Referring to Fig. 1, in the state where a voltage equal to or less than a threshold value is applied to gate electrode 10, that is, in the OFF state, a reverse bias is applied between p region 23 located directly below oxide film 26 as a gate insulating film and reverse breakdown voltage holding layer 22 having n type conductivity. This brings about a non-conductive state. In contrast, when a positive voltage is applied to gate electrode 10, an inversion layer is formed in the channel region in the vicinity of the area where p region 23 is in contact with oxide film 26. Consequently, n⁺ region 24 and reverse breakdown voltage holding layer 22 are electrically connected to each other, thereby causing a current to flow between source electrode 11 and drain electrode 12.

The method of manufacturing semiconductor device 1 shown in Fig. 1 will then be described. Referring to Fig. 2, the manufacturing method in the first example of the semiconductor device that can be formed according to the present invention will be described.

First, as shown in Fig. 2, the substrate preparing step (S10) is carried out. In this step, a silicon carbide substrate is prepared in which, specifically, a (0001) plane has an off angle of 8 degrees in the <11-20> direction. The silicon carbide substrate has n type conductivity. The above-described substrate 2 (see Fig. 1) can be obtained, for example, by the method in which the substrate is cut out from an SiC ingot having a (0001) plane as a main surface so as to form the above-described off angle.

Then, the buffer layer forming step (S20) is carried out. Specifically, an epitaxial layer made of silicon carbide having n type conductivity is formed as a buffer layer. It is to be noted that this buffer layer forming step (S20) may not be carried out, but the epitaxial layer forming step (S30) described below may be carried out subsequent to the above-described step (S10).

Then, the epitaxial layer forming step (S30) is carried out. Specifically, reverse breakdown voltage holding layer 22 is formed on buffer layer 21. Reverse breakdown voltage holding layer 22 is formed by the epitaxial growth method as a layer made of silicon carbide having n type conductivity. In this epitaxial layer forming step (S30), for example, SiH₄ gas and C₃H₈ gas can be used as source gas.

Then, the implantation step (S40) is carried out. Specifically, the oxide film formed using photolithography and etching is used as a mask to implant the impurities of p type conductivity into reverse breakdown voltage holding layer 22. In this way, p region 23 (see Fig. 1) is formed. Furthermore, after removing the oxide film used in the above-described implantation step, an oxide film having a new pattern is again formed using photolithography and etching. Then, the oxide film is used as a mask to implant the n type conductive impurities into a predetermined region, so that n⁺ region 24 is formed (see Fig. 1). The p type conductive impurities are implanted using the same method to thereby form p⁺ region 25.

After the implantation step (S40) as described above, the activation heat treatment is performed. This activation heat treatment may be performed, for example, on the conditions that argon gas is used as atmospheric gas, the heating temperature is set at 1700 °C and the heating time period is 30 minutes.

Then, as shown in Fig. 2, the gate insulating film forming step (S50) is carried out. Specifically, an oxide film which is to serve as oxide film 26 (see Fig. 1) is formed so as to cover reverse breakdown voltage holding layer 22, p region 23, n⁺ region 24, and p⁺ region 25. The method of forming an oxide film that is to serve as a gate insulating film may include dry oxidation (thermal oxidation), for example. This dry oxidation may be performed, for example, on the conditions that, in oxygen-containing atmosphere, the heating temperature is set at 1200 °C and the heating time period is 30 minutes.

Then, the electrode forming step (S60) is carried out. Specifically, a resist film having a pattern is formed on the oxide film using photolithography. The resist film is used as a mask to remove a portion of the oxide film located on n⁺ region 24 and p⁺ region 25 by etching. Then, a conductor film made of metal and the like is formed so as to be in contact with n⁺ region 24 and p⁺ region 25 within the opening provided on the resist film and in the oxide film. The resist film is then removed to remove (lift off) the conductor film located on the resist film.

In this case, for example, nickel (Ni) may be used for a material of the conductor film. Furthermore, the material to be used may include titanium (Ti), aluminum (Al), and a material containing silicon (Si) in these metals. Consequently, source electrode 11 can be obtained as shown in Fig. 1. Drain electrode 12 (see Fig. 1) is also formed on the backside of substrate 2. It is to be noted that it is preferable to perform heat treatment for alloying. Specifically, for example, argon (Ar) which is inert gas may be used as atmospheric gas to perform heat treatment (alloying process) on the conditions that the heating temperature is set at 950 °C and the heating time period is 2 minutes.

Upper source electrode 27 (see Fig. 1) is then formed on source electrode 11. Also in this case, gate electrode 10 is formed on oxide film 26 so as to extend from the portion above one of n⁺ regions 24 to the portion above the other of n⁺ regions 24. Thus, the semiconductor device shown in Fig. 1 can be obtained.

### [Second Example]

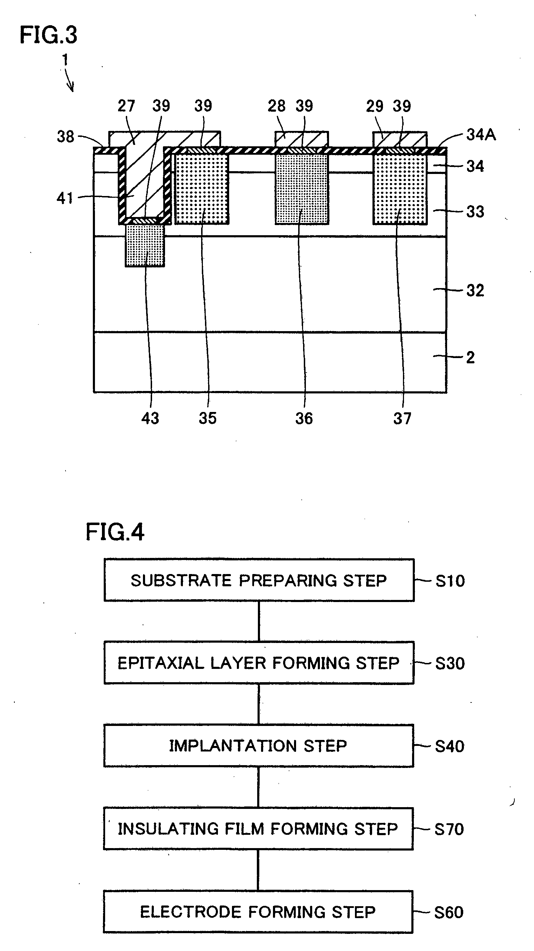

Referring to Fig. 3, the second example of the semiconductor device that can be formed according to the present invention will then be described.

Referring to Fig. 3, a semiconductor device 1 is a JFET having a lateral structure which is an example of a silicon carbide semiconductor device. Semiconductor device 1 is made of silicon carbide (SiC) and includes a substrate 2 having n type conductivity, a first p type layer 32, an n type layer 33, a second p type layer 34, a source region 35, a gate region 36, a drain region 37, an oxide film 38, a contact electrode 39, an upper source electrode 27, an upper gate electrode 28, an upper drain electrode 29, and a potential holding region 43. First p type layer 32 is formed on the upper surface of substrate 2. First p type layer 32 can be configured to have a thickness of 10 µm, for example. Furthermore, the concentration of the p type conductive impurities in first p type layer 32 can be set at 1 × 10¹⁶ cm⁻³, for example. N type layer 33 is formed on first p type layer 32. N type layer 33 can be configured to have a thickness of 0.4 µm, for example. Furthermore, the concentration of the n type conductive impurities in n type layer 33 can be set at 2 × 10¹⁷ cm⁻³, for example. Second p type layer 34 is formed on n type layer 33. Second p type layer 34 can be configured to have a thickness of 0.3 µm, for example. Furthermore, the concentration of the p type conductive impurities in second p type layer 34 can be set at 2 × 10¹⁷ cm⁻³, for example. The above-described p type layer and n type layer each are made of silicon carbide having p type conductivity and n type conductivity, respectively.

In second p type layer 34 and n type layer 33, source region 35 and drain region 37 are formed that contain impurities of n type conductivity (n type impurities) which are higher in concentration than those of n type layer 33. Furthermore, in second p type layer 34 and n type layer 33, gate region 36 is formed such that it is sandwiched between the above-described source region 35 and drain region 37, in which case gate region 36 contains impurities of p type conductivity (p type impurities) which are higher in concentration than those of each of first p type layer 32 and second p type layer 34. Thus, source region 35, gate region 36 and drain region 37 are formed so as to extend through second p type layer 34 to n type layer 33. Furthermore, the bottom of each of source region 35, gate region 36 and drain region 37 is located spaced apart from the upper surface of first p type layer 32 (boundary area between first p type layer 32 and n type layer 33).

Furthermore, on the side opposite to gate region 36 with respect to source region 35, a groove 41 is provided so as to extend from an upper surface 34A of second p type layer 34 (the main surface on the side opposite to the surface facing n type layer 33) through second p type layer 34 to n type layer 33. The bottom wall of groove 41 is located within n type layer 33 and spaced apart from the interface between first p type layer 32 and n type layer 33. Furthermore, potential holding region 43 is formed so as to extend from the bottom wall of groove 41 through n type layer 33 to first p type layer 32, in which case potential holding region 43 contains p type impurities which are higher in concentration than those of first p type layer 32 and second p type layer 34. The bottom of this potential holding region 43 is located spaced apart from the upper surface of n type substrate 2 (the boundary area between substrate 2 and first p type layer 32).

Contact electrode 39 is formed so as to be in contact with the upper surface of each of source region 35, gate region 36, drain region 37, and potential holding region 43. Contact electrode 39 is made of material that allows ohmic contact with source region 35, gate region 36, drain region 37, and potential holding region 43. A contact electrode 39 may be made of Ni, for example. Furthermore, contact electrode 39 may be made of Ti, Al, or silicide of these metals.

Oxide film 38 is formed between contact electrodes 39 adjacent to each other. In other words, oxide film 38 serving as an insulating layer is formed on the upper surface of second p type layer 34 and the bottom wall and the sidewall of groove 41 so as to cover the entire region other than the region where contact electrode 39 is formed. Consequently, adjoining contact electrodes 39 are insulated from each other.

Upper source electrode 27, upper gate electrode 28 and upper drain electrode 29 are formed so as to be in contact with the upper surface of each contact electrode 39 located on source region 35, gate region 36 and drain region 37, respectively. Consequently, upper source electrode 27, upper gate electrode 28 and upper drain electrode 29 are electrically connected through contact electrode 39 to source region 35, gate region 36 and drain region 37, respectively. Furthermore, upper source electrode 27 is formed so as to extend from the upper surface of contact electrode 39 on source region 35 to the upper surface of contact electrode 39 on potential holding region 43. Consequently, contact electrode 39 on potential holding region 43 is maintained at the same electric potential as that of contact electrode 39 on source region 35. Upper source electrode 27, upper gate electrode 28 and upper drain electrode 29 each are made of a conductor such as Al, for example.

Semiconductor device 1 shown in Fig. 3 includes substrate 2 and gate region 36 as an impurity layer. Substrate 2 is made of silicon carbide, has a dislocation density of 5 × 10³ cm⁻² or less, and has the first conductive type (n type). Gate region 36 serving as an impurity layer is formed on substrate 2, in which the concentration of the conductive impurities having the second conductive type (p type) different from the n type is 1 × 10²⁰ cm⁻² or more and 5 × 10²¹ cm⁻³ or less.

In this way, as in the case of semiconductor device 1 shown in the first embodiment, when contact electrode 39 serving as an ohmic electrode is formed so as to be in contact with gate region 36 serving as an impurity layer, the contact resistance between contact electrode 39 and gate region 36 can be lowered to the level at which there is no problem from a practical standpoint. Furthermore, substrate 2 having a dislocation density lowered to the above-mentioned value is used, which allows a sufficient decrease in the density of the defects that may lead to a leak path in substrate 2 and the epitaxial layer (first p type layer 32, n type layer 33 and second p type layer 34) formed on the substrate. Accordingly, the reverse breakdown voltage characteristics of semiconductor device 1 can be better.

Then, the operation of semiconductor device 1 will be briefly described. Referring to Fig. 3, in the state where the voltage applied to upper gate electrode 28 is 0 V, depletion does not occur in the region sandwiched between gate region 36 and drain region 37 in n type layer 33 and the region sandwiched between the above-mentioned sandwiched region and first p type layer 32 (drift region), and the region sandwiched between gate region 36 and first p type layer 32 (channel region). This causes the state where source region 35 and drain region 37 to be electrically connected to each other through n type layer 33. Accordingly, electrons move from source region 35 toward drain region 37, which causes the current to flow.

In addition, when a negative voltage is applied to upper gate electrode 28, depletion in the above-described channel region and drift region is developed. This results in the state where source region 35 and drain region 37 are electrically interrupted. Accordingly, electrons cannot move from source region 35 toward drain region 37, which prevents the current from flowing.

Then, the manufacturing method of the semiconductor device shown in Fig. 3 will be described. Referring to Fig. 4, the manufacturing method in the second example of the semiconductor device that can be formed according to the present invention will then be described.

As shown in Fig. 4, in the method of manufacturing semiconductor device 1 shown in Fig. 3, the substrate preparing step (S10) is first carried out. Specifically, as in the step (S10) shown in Fig. 2, substrate 2 made of silicon carbide is prepared that has n type conductivity and has a dislocation density of 5 × 10³ cm⁻² or less.

As shown in Fig. 4, the epitaxial layer forming step (S30) is then carried out. Specifically, on one of the main surfaces of substrate 2 prepared in the above-described step (S10), first p type layer 32, n type layer 33 and second p type layer 34 each made of silicon carbide are sequentially formed, for example, using the vapor phase epitaxial growth method. In the vapor phase epitaxial growth method, for example, silane (SiH₄) gas and propane (C₃H₈) gas can be used as material gas. In this case, for example, hydrogen (H₂) gas can also be used as carrier gas. Furthermore, in order to form a p type layer, for example, diborane (B₂H₆) and trimethyl aluminum (TMA) can be used as a p type impurity source used for introducing p type conductive impurities. Furthermore, for example, nitrogen (N₂) gas can be used as an n type impurity source used for forming an n type layer.

Then, a groove is formed in second p type layer 34 and n type layer 33 formed as described above. Specifically, for example, dry etching is used to form groove 41 so as to extend from upper surface 34A of second p type layer 34 through second p type layer 34 to n type layer 33. In this step of forming groove 41, for example, a mask layer having an opening in the position where groove 41 is to be formed may be formed on upper surface 34A of second p type layer 34, and this mask layer may be used as a mask for dry etching using SF₆ gas.

Then, the implantation step (S40) is carried out as shown in Fig. 4. Specifically, as the first ion implantation step, source region 35 and drain region 37 are first formed which contain n type impurities of high concentration. Specifically, after applying a resist onto upper surface 34A of second p type layer 34 and the inner wall of groove 41, the exposure and development process is performed (by photolithography), thereby forming a resist film having an opening in the region in accordance with the desired shape of each of source region 35 and drain region 37. Then, this resist film is used as a mask to implant n type impurities such as phosphorus (P) or nitrogen (N) into second p type layer 34 and n type layer 33 by the ion implantation method. Consequently, source region 35 and drain region 37 are formed.

Then, the second ion implantation step is carried out as an implantation step (S40). Specifically, as in the above-described first ion implantation step, the photolithography method is used to form a resist film having an opening in the region in accordance with the desired planar shape of each of gate region 36 and potential holding region 43. Then, this resist film is used as a mask to introduce p type impurities such as aluminum (Al) or boron (B) into the predetermined region of each of second p type layer 34, n type layer 33 and first p type layer 32 by the ion implantation method. Consequently, gate region 36 and potential holding region 43 are formed.

Then, the activation annealing step for activating the implanted n type impurities or p type impurities is carried out. In this activation annealing step, removal of the resist film used in the above-described implantation step (S40) is followed by heating of second p type layer 34, n type layer 33 and first p type layer 32 into which ions are implanted. Consequently, the impurities introduced by the above-described ion implantation are activated. The activation annealing treatment may be performed, for example, on the conditions that argon gas is used as an atmosphere, the heating temperature is set at about 1700 °C and the holding time period is about 30 minutes.

Then, the insulating film forming step (S70) is carried out as shown in Fig. 4. In this step (S70), the above-described step is carried out, to thereby cause thermal oxidization of the surface of substrate 2 on which second p type layer 34, n type layer 33 and first p type layer 32 are formed, each having a prescribed ion implantation layer formed therein. Accordingly, oxide film 38 made of silicon dioxide (SiO₂) is formed so as to cover upper surface 34A of second p type layer 34 and the inner wall of groove 41.

The electrode forming step (S60) is then carried out as shown in Fig. 4. Specifically, contact electrode 39 is formed so as to be in contact with the upper surface of each of source region 35, gate region 36, drain region 37, and potential holding region 43. In the method of forming contact electrode 39, the photolithography method is first used to form a resist film having an opening pattern in the region in accordance with the planar shape of contact electrode 39 that is to be formed. Then, this resist film is used as a mask to partially remove oxide film 38 on source region 35, gate region 36, drain region 37, and potential holding region 43, for example, by reactive ion etching (RIE). Then, for example, vapor deposition of nickel (Ni) is carried out to form a conductor layer (nickel film) on the upper surface of the resist film and the upper surface of each of source region 35, gate region 36, drain region 37 and potential holding region 43 which are exposed from the opening provided by partially removing oxide film 38. Then, the resist film is removed, so that the conductor layer on the resist film is removed (lifted off). Consequently, the conductor layer remains on the upper surface of each of source region 35, gate region 36, drain region 37, and potential holding region 43 which are exposed from the opening of oxide film 38. Then, the heat treatment process for heating, for example, to approximately 1000 °C is performed for silicidation of the above-described conductor layer. This results in formation of contact electrode 39 that is made of NiSi (nickel silicide) allowing ohmic contact with source region 35, gate region 36, drain region 37, and potential holding region 43. In addition, contact electrode 39 may be made of Ti, Al, or silicide thereof.

Then, upper source electrode 27, upper gate electrode 28 and upper drain electrode 29 are formed on contact electrode 39. Specifically, a resist film having the same opening pattern as the planar shape of each of upper source electrode 27, upper gate electrode 28 and upper drain electrode 29 is formed on oxide film 38. Within the opening pattern of this resist film, contact electrode 39 is exposed. Then, a conductor film such as aluminum is vapor-deposited on the upper surface of the resist film and within the opening pattern. Then, the conductor film on the resist film is removed (lifted off) together with the resist film. Consequently, upper source electrode 27, upper gate electrode 28 and upper drain electrode 29 as shown in Fig. 3 can be formed. Thus, the semiconductor device as shown in Fig. 3 can be achieved.

Then, a preferable variation of the semiconductor device shown in the above-described first and second embodiments will be described.

In the above-described semiconductor device 1, substrate 2 may have a dislocation density of 1 × 10³ cm⁻² or less. In this case, the reverse breakdown voltage characteristics of semiconductor device 1 can be much better.

In the above-described semiconductor device 1, substrate 2 may have a screw dislocation density of 1 cm⁻² or less. In this case, since the screw dislocation in substrate 2 may lead to deterioration of the reverse breakdown voltage characteristics (may cause a decrease in the avalanche breakdown voltage), it is particularly effective to decrease the density. In this case, the upper limit of the screw dislocation density of substrate 2 is set at 1 cm⁻². This is because the screw dislocation density exceeding this upper limit value may lead to deterioration of the reverse breakdown voltage.

In the above-described semiconductor device 1, substrate 2 may have a screw dislocation density of 0.1 cm⁻² or less. In this case, the reverse breakdown voltage characteristics of semiconductor device 1 can be much better. The more preferable upper limit of the screw dislocation density of substrate 2 is set at 0.1 cm⁻². This is because this upper limit value set as described above reliably allows improvement in the reverse breakdown voltage.

In the above-described semiconductor device 1, the concentration of the second (p type) conductive impurities in p⁺ region 25 or gate region 36 as an impurity layer may be 4 × 10²⁰ cm⁻² or more and 5 × 10²¹ cm⁻³ or less. In this case, when source electrode 11 or contact electrode 39 serving as an ohmic electrode is formed so as to be in contact with the impurity layer, the contact resistance between source electrode 11 and p⁺ region 25 or between contact electrode 39 and gate region 36 can be further lowered. The more preferable lower limit of the concentration of the conductive impurities is set at 4 × 10²⁰ cm⁻³ because this lower limit allows the contact resistance to be further lowered. Furthermore, the more preferable upper limit of the concentration of the conductive impurities is set at 5 × 10²¹ cm⁻³. This is because when the conductive impurities are introduced beyond this upper limit, the crystallinity of the impurity layer may be degraded, which leads to deterioration of the characteristics of the silicon carbide semiconductor device.

The above-described semiconductor device 1 may include an ohmic electrode (source electrode 11) formed so as to be in contact with the impurity layer (p⁺ region 25) and another ohmic electrode (drain electrode 12) formed so as to be in contact with substrate 2. Source electrode 11 and drain electrode 12 may be made of the same material. In this case, since the above-described source electrode 11 and drain electrode 12 can be formed using the same material, source electrode 11 and drain electrode 12 can be simultaneously or sequentially formed. Accordingly, the manufacturing process of semiconductor device 1 can be simplified as compared with the case where source electrode 11 and drain electrode 12 are made of different materials.

In the above-described semiconductor device 1, the material forming source electrode 11 and drain electrode 12 may include nickel (Ni). In this case, the material containing nickel is employed to form source electrode 11 and drain electrode 12 which are in contact with the impurity layer (p⁺ region 25) and substrate 2, respectively, which are different in conductive type. Consequently, the same material can be used to form the electrodes (source electrode 11 and drain electrode 12) which are in ohmic contact with the impurity layer (p⁺ region 25) and substrate 2.

In the above-described semiconductor device 1, the material forming each of source electrode 11 and drain electrode 12 may include titanium (Ti) and aluminum (Al). Furthermore, in the above-described semiconductor device 1, the material forming source electrode 11 and drain electrode 12 may include silicon (Si) in addition to titanium and aluminum. In this case, the same material can be used to form the electrodes (source electrode 11 and drain electrode 12) which are in ohmic contact with the impurity layer (p⁺ region 25) and substrate 2, respectively, which are different in conductive type.

In the above-described semiconductor device 1, the material forming the above-described source electrode 11 and drain electrode 12 or contact electrode 39 may include a stacking structure of titanium, aluminum and silicon. In this case, for example, the thickness of titanium may be 0 nm or more and 40 nm or less, the thickness of aluminum may be 20 nm or more and 100 nm or less, and the thickness of silicon may be 10 nm or more and 50 nm or less. More preferably, the thickness of titanium may be 5 nm or more and 30 nm or less, the thickness of aluminum may be 30 nm or more and 70 nm or less, and the thickness of silicon may be 15 nm or more and 35 nm or less.

### [Example 1 of the invention]

The following experiments were conducted in order to confirm the effects of the present invention.

### [Sample]

### Sample of Inventive Example:

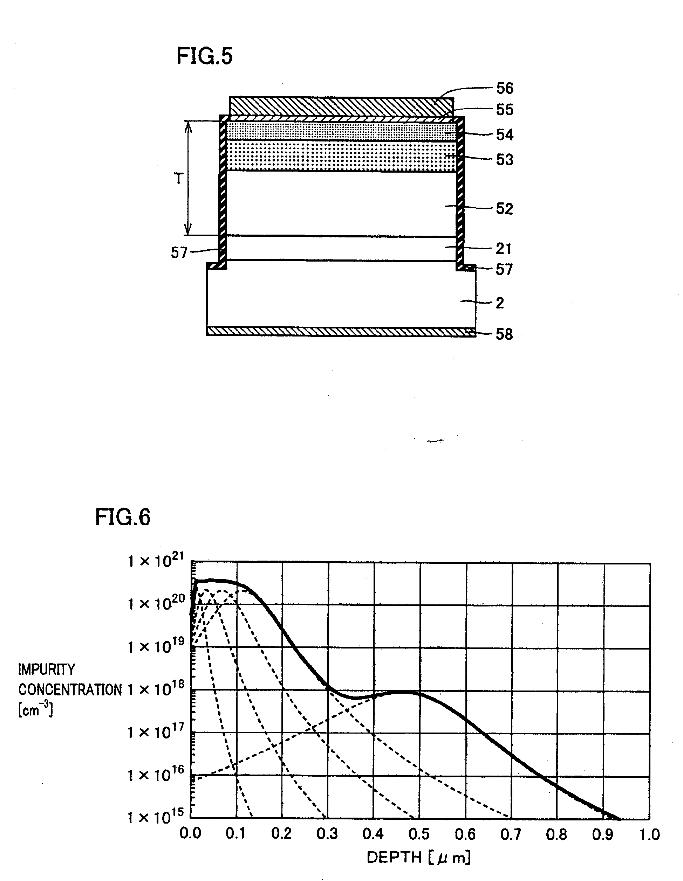

Fig. 5 is a schematic cross-sectional view of a sample of the inventive example produced for experiments. Referring to Fig. 5, the structure of the sample of the inventive example produced in the example will then be described.

As shown in Fig. 5, in the device that is a sample of the inventive example, a buffer layer 21 is formed on the main surface of substrate 2. On this buffer layer 21, an n⁻ type layer 52 is formed. A p type layer 53 is formed on this n⁻ type layer 52. A p⁺ type layer 54 is formed on p type layer 53. An ohmic electrode 55 is formed on the upper surface of this p⁺ type layer 54. On the upper surface of ohmic electrode 55, an electrode 56 made of aluminum is formed. Furthermore, an insulating film 57 made of an oxide film is formed on the side surface of the device so as to extend from the end face of ohmic electrode 55 to the upper surface of substrate 2. Furthermore, a backside electrode 58 is formed on the backside of substrate 2 (the backside opposite to the surface on which buffer layer 51 is formed).

Substrate 2 made of silicon carbide was prepared. This substrate 2 had a (0001) plane having an off angle of 8 degrees in the <11-20> direction. The dislocation density of substrate 2 was 1 × 10³ cm⁻². The concentration of the n type conductive impurities in buffer layer 21 was 5 × 10¹⁷ cm⁻³. Nitrogen was used as n type conductive impurities. Furthermore, buffer layer 21 was configured to have a thickness of 0.5 µm.

Furthermore, the concentration of the n type conductive impurities in n⁻ type layer 52 was set at 5 × 10¹⁵ cm⁻³. The thickness of n⁻ type layer 52 was 2.2 µm. It is to be noted that elements similar to those of the above-described buffer layer 21 were used for n type conductive impurities in n⁻ type layer 52. Furthermore, the concentration profile of the conductive impurities in p type layer 53 and p⁺ type layer 54 is as shown in Fig. 6.

Referring to Fig. 6, the horizontal axis shows the depth from the upper surface of p⁺ type layer 54 toward substrate 2 (unit: µm), and the vertical axis shows the concentration of the p type conductive impurities. As can be seen also from Fig. 6, the thickness of p⁺ type layer 54 is about 0.1 µm, and the concentration of the conductive impurities thereof is about 3 × 10²⁰ cm⁻³. Furthermore, p type layer 53 has a thickness of about 0.8 µm and shows a concentration distribution of the conductive impurities as shown in Fig. 6. The semiconductor device shown in Fig. 5 has a circular planar shape and a diameter thereof is 500 µm.

### Sample of Comparative Example 1a:

For the sample of the comparative example 1a, a substrate having a similar structure but having a dislocation density in substrate 2 of 1 × 10⁴ cm⁻² was used. Other structures are similar to those of the sample of the inventive example shown in Fig. 5.

### Sample of Comparative Example 1b:

The sample of Comparative Example 1b is also similar in structure to the semiconductor device shown in Fig. 5, but is different from the sample of the inventive example in the dislocation density in substrate 2 and the concentration of the conductive impurities in p⁺ type layer 54. Specifically, the dislocation density in substrate 2 corresponding to a component of the semiconductor device of Comparative Example 1b was set at 1 × 10⁴ cm⁻². Furthermore, the concentration of the conductive impurities in p⁺ type layer 54 was set at 5 × 10¹⁹ cm⁻³.

### [Measurement]

With regard to the samples of the above-described inventive example and Comparative Examples 1a and 1b, the contact resistance between ohmic electrode 55 and p⁺ type layer 54 as well as the current-voltage characteristics in the reverse direction for the formed samples were measured. The TLM (Transmission Line Model) method was used as a method for measuring the contact resistance. Furthermore, the method of current-voltage characteristics measurement by a curve tracer was used as a method for measuring the current-voltage characteristics in the reverse direction.

### [Results]

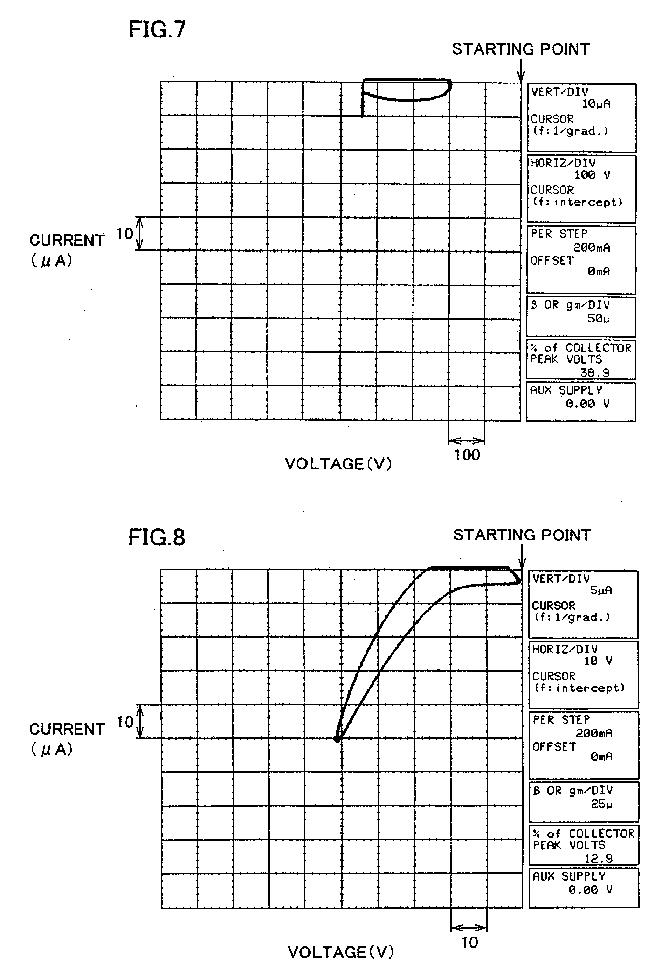

The measurement results of the inventive example are shown in Fig. 7. In Fig. 7, the vertical axis shows a current (µA), and the horizontal axis shows a voltage (V). One scale in the vertical axis corresponds to 10 µA, and one scale in the horizontal axis corresponds to 100 V. It is to be noted that the upper right corner is assumed to be a starting point in the graph shown in Fig. 7.

As can be seen from Fig. 7, in the sample of the inventive example, avalanche breakdown occurs at about 450 V. The above-described data means that the sample showed a nearly ideal reverse breakdown voltage. Furthermore, the contact resistance between ohmic electrode 55 and p⁺ type layer 54 in the sample of the inventive example was 2 × 10⁻³ Ω cm⁻².

Then, the measurement results of Comparative Example 1a are shown in Fig. 8. The vertical axis and horizontal axis in the graph shown in Fig. 8 are the same as those in the graph shown in Fig. 7. It is to be noted that one scale in the horizontal axis in Fig. 8 corresponds to 10 V. As can be seen also from Fig. 8, a leakage current was detected from a relatively low voltage (approximately 25 V) in the sample of Comparative Example 1a. Furthermore, the contact resistance of ohmic electrode 55 was 2 × 10⁻³ Ω cm⁻². The contact resistance itself of this ohmic electrode was almost equal to the contact resistance of the ohmic electrode in the sample of the above-described inventive example.

As for the sample of Comparative Example 1b, the current-voltage characteristics in the reverse direction are the same as those of the sample of Comparative Example 1a, and a leakage current was detected from the relatively low voltage. Furthermore, in the sample of Comparative Example 1b, the contact resistance of the ohmic electrode was 2 × 10⁻² Ω cm⁻² which was greater than the contact resistance of the sample of each of sample of Inventive Example and Comparative Example 1a.

### [Comparative Example 2]

The following experiments were conducted in order to confirm the relationship between the reverse breakdown voltage and the dislocation density of the substrate in the present invention.

### [Sample]

As in Example 1 of the invention, the samples each having the structure shown in Fig. 5 was prepared as a sample for measurement. In this case, each sample was produced using substrates 2 having different dislocation densities (eight types of substrates having the dislocation densities distributed in the range of 1 × 10³ cm⁻² to 1 × 10⁵ cm⁻²). In addition, the concentration of the conductive impurities in p⁺ type layer 54 in each sample was set at 4 × 10²⁰ cm⁻³. Other structures are the same as those of the sample in Example 1.

### [Measurement]

The method similar to that in Example 1 was employed to measure the current-voltage characteristics in the reverse direction for each sample. Then, the voltage at the time when the flowed current (leakage current) exceeded 10 µA was defined as a reverse breakdown voltage, to determine the value of the reverse breakdown voltage for each sample.

### [Results]

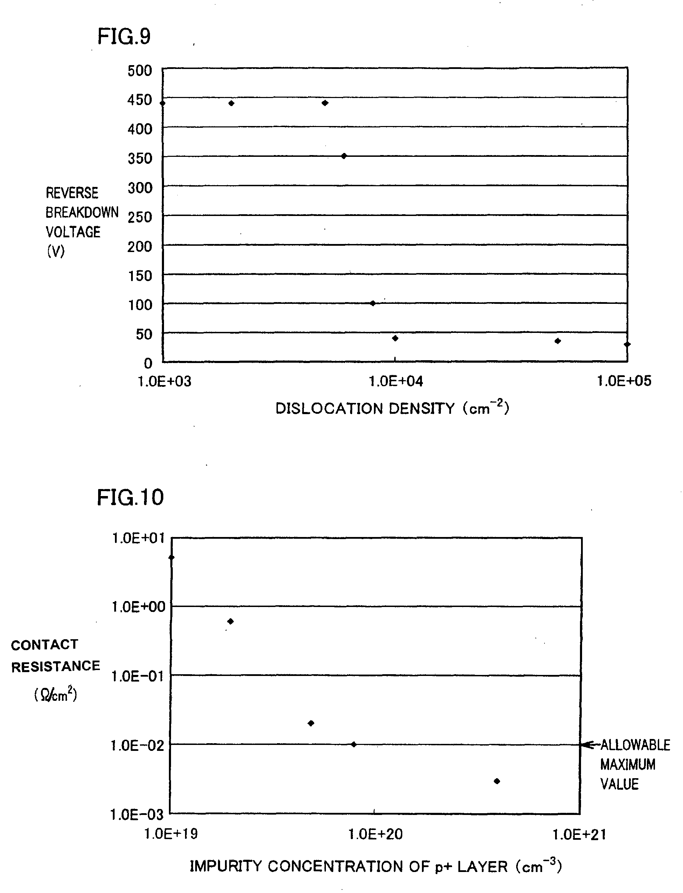

The measurement results are shown in Fig. 9. Referring to Fig. 9, the horizontal axis shows a dislocation density of the substrate in each sample (unit: cm⁻²), and the vertical axis shows a reverse breakdown voltage (unit: V). As can be seen from Fig. 9, when the dislocation density of the substrate is approximately 5 × 10³ cm⁻² or less, the reverse breakdown voltage is sufficiently high. In contrast, when the dislocation density exceeds 1 × 10⁴ cm⁻², the reverse breakdown voltage is 50 V or less which is extremely low. This shows that the dislocation density of the substrate only needs to be set at 5 × 10³ cm⁻².

### [Comparative Example 3]

The following experiments were conducted in order to confirm the relationship between the contact resistance of the ohmic electrode and the concentration of the conductive impurities of the impurity layer formed so as to be in contact with the ohmic electrode, in accordance with the present invention.

### [Sample]

As in the inventive example of Example 1, the samples each having the structure shown in Fig. 5 was prepared as a sample for measurement. In this case, the samples were prepared in which each p⁺ type layer 54 corresponding to the impurity layer of the present invention has a different impurity concentration (five types of samples in which the impurity concentrations of p⁺ type layers 54 are distributed in the range of 1 × 10¹⁹ cm⁻³ to 5 × 10²⁰ cm⁻³). It is to be noted that other structures are similar to those of the sample of the inventive example in Example 1.

### [Measurement]

The method similar to that in Example 1 was employed to measure the contact resistance between ohmic electrode 55 and p⁺ type layer 54 for each sample.

### [Results]

Fig. 10 shows the measurement results. Referring to Fig. 10, the horizontal axis shows the impurity concentration of the p⁺ type layer in each sample (unit: cm⁻³), and the vertical axis shows the contact resistance (also referred to as contact resistivity) (unit: Ω cm⁻²).

As can be seen from Fig. 10, the contact resistance is lowered in accordance with an increase in the impurity concentration of p⁺ type layer 54. Then, it turns out that when the allowable maximum value of the contact resistance is defined as 1 × 10⁻² Ω cm⁻², the impurity concentration of p⁺ type layer 54 set at 1 × 10²⁰ cm⁻³ or more allows the contact resistance to fall within the allowable range (set at a sufficiently low value).

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention can be applied to a silicon carbide semiconductor device having an ohmic electrode, and particularly, is advantageously applied to a DiMOSFET, a JFET, and the like.

### DESCRIPTION OF THE REFERENCE SIGNS

1 semiconductor device, 2 substrate, 10 gate electrode, 11 source electrode, 12 drain electrode, 19 contact electrode, 21, 51 buffer layer, 22 reverse breakdown voltage holding layer, 23 p region, 24 n⁺ region, 25 p⁺ region, 26, 38 oxide film, 27 upper source electrode, 28 upper gate electrode, 29 upper drain electrode, 32 first p type layer, 33 n type layer, 34 second p type layer, 34A upper surface, 35 source region, 36 gate region, 37 drain region, 39 contact electrode, 41 groove, 43 potential holding region, 52 n⁻ type layer, 53 p type layer, 54 p⁺ type layer, 55 ohmic electrode, 56 electrode, 57 insulating film, 58 backside electrode.

## Claims

1. A silicon carbide semiconductor device (1) comprising:
a substrate (2) of a n type conductivity made of silicon carbide and having a dislocation density of 1 x 10³ cm⁻² ; and
a p-type impurity layer (25, 36, 54) formed by ion-implantation of Al or B in a layer formed on said substrate (2), a concentration of said p-type conductive impurities being 3 x 10²⁰ cm⁻³,
an ohmic electrode (11, 55) formed so as to be in contact with said impurity layer (25, 36, 54); wherein the ohmic electrode is made of Ni, Ti, Al, or a silicide thereof,
wherein a contact resistance is 2 x 10⁻³ ohm/cm².

2. The silicon carbide semiconductor device (1) according to claim 1, comprising:
another ohmic electrode (12, 58) formed so as to be in contact with said substrate (2), wherein a material forming said ohmic electrode (11, 55) is identical to a material forming said another ohmic electrode (12, 58).

## Patentansprüche

1. Siliziumkarbid-Halbleitervorrichtung (1), umfassend:
ein Substrat (2) mit einem n-Leitfähigkeitstyp, das aus Siliziumkarbid gebildet ist und eine Versetzungsdichte von 5 x 10³ cm⁻² aufweist;
eine p- Verunreinigungsschicht (25, 36, 54), die durch Ionenimplantation von Al oder B in einer auf dem Substrat (2) gebildeten Schicht gebildet ist, wobei eine Konzentration der leitenden p-Verunreinigungen 3 x 10²⁰ cm⁻³ beträgt, und
eine ohmsche Elektrode (11, 55), die in Kontakt mit der Verunreinigungsschicht (25, 36, 54) ausgebildet ist; wobei die ohmsche Elektrode aus Ni, Ti, Al oder einem Silizid davon gebildet ist,
wobei ein Kontaktwiderstand 2 x 10⁻³ Ω/cm² beträgt.

2. Siliziumkarbid-Halbleitervorrichtung (1) nach Anspruch 1, umfassend:
eine weitere ohmsche Elektrode (12, 58), die in Kontakt mit dem Substrat (2) ausgebildet ist, wobei ein die ohmsche Elektrode (11, 55) bildendes Material identisch zu einem Material ist, das die weitere ohmsche Elektrode (12, 58) bildet.

## Revendications

1. Dispositif à semi-conducteur au carbure de silicium (1) comportant :
un substrat (2) en carbure de silicium ayant une conductivité de type n et ayant une densité de dislocations de 1 x 10³ cm⁻² ; et
une couche d'impuretés de type p (25, 36, 54) formée par implantation ionique d'Al ou de B dans une couche formée sur ledit substrat (2), une concentration desdites impuretés conductrices de type p étant de 3 x 10²⁰ cm⁻³,
une électrode ohmique (11, 55) formée de manière à ce qu'elle soit en contact avec ladite couche d'impuretés (25, 36, 54) ; où l'électrode ohmique est en Ni, Ti, Al ou un de leur siliciures,
où une résistance de contact est de 2 x 10⁻³ ohm/cm².

2. Dispositif à semi-conducteur au carbure de silicium (1) selon la revendication 1, comportant :
une autre électrode ohmique (12, 58) formée de manière à ce qu'elle soit en contact avec ledit substrat (2), où un matériau formant ladite électrode ohmique (11, 55) est identique au matériau formant ladite autre électrode ohmique (12, 58).
